# EUROPÄISCHE PATENTSCHRIFT

(11) **EP 3 563 650 B1**
(45) Veröffentlichungstag und Bekanntmachung des Hinweises auf die Patenterteilung: **06.01.2021**
(21) Anmeldenummer: 17804819.5
(22) Anmeldetag: 07.11.2017
(51) Int. Cl.: H05K 7/20

(54) **KÜHLVORRICHTUNG, UMRICHTER MIT EINER KÜHLVORRICHTUNG UND VERFAHREN ZUR KÜHLUNG EINES UMRICHTERS**
COOLING DEVICE, CONVERTER WITH A COOLING DEVICE AND METHOD FOR COOLING A CONVERTER
DISPOSITIF DE REFROIDISSEMENT, CONVERTISSEUR COMPRENANT UN DISPOSITIF DE DE REFROIDISSEMENT ET PROCÉDÉ DE REFROIDISSEMENT D'UN CONVERTISSEUR

(30) Priorität: 15.02.2017 EP 17156233
(43) Veröffentlichungstag der Anmeldung: 06.11.2019
(73) Patentinhaber: Siemens Aktiengesellschaft, 80333 München (DE)
(72) Erfinder: DANOV, Vladimir, 91056 Erlangen (DE); MÜLLER, Volker, 90408 Nürnberg (DE)
(86) Internationale Anmeldenummer: PCT/EP2017/078393
(87) Internationale Veröffentlichungsnummer: WO 2018/149522

(56) Entgegenhaltungen:
- EP-A1- 2 734 020
- US-A1- 2009 056 916
- US-A1- 2011 277 967
- US-A1- 2015 077 938

## Beschreibung

Die Erfindung betrifft eine Kühlvorrichtung zur Kühlung elektrischer Komponenten eines Umrichters. Weiterhin betrifft die Erfindung einen Umrichter, der eine erfindungsgemäße Kühlvorrichtung umfasst. Ferner betrifft die Erfindung ein Verfahren zur Kühlung elektrischer Komponenten eines Umrichters.

Typischerweise ergeben sich bei einem Betrieb eines Umrichters Verlustleistungen, welche auf dem begrenzten Wirkungsgrad der verwendeten elektrischen Komponenten des Umrichters zurückzuführen ist. Die größten Verlustleistungen weisen beispielsweise Wechselrichter, Symmetriewiderstände, Zwischenkreiskondensatoren oder Zusatzkomponenten, beispielsweise Gleichrichter, auf. Die elektrischen Komponenten erfordern folglich eine stetige Abfuhr der durch ihre Verlustleistung erzeugten Wärme, damit die Betriebssicherheit des Umrichters sichergestellt ist.

Der Stand der Technik, wie beispielsweise EP 2 734 020 A1, unterscheidet Luftkühlungen und Flüssigkeitskühlungen. Typischerweise werden die zu kühlenden elektrischen Komponenten auf einen Kühlkörper aufgeschraubt, der mit einem Kühlfluid im thermischen Kontakt ist. Weiterhin werden die elektrischen Komponenten an einer stromführenden Schiene, beispielsweise mittels einer Verschraubung, befestigt.

Aus dem Stand der Technik sind Umrichter bekannt, die mittels eines Thermosiphons gekühlt werden. Bei einem Thermosiphon wird die Verlustleistung dazu verwendet eine Flüssigkeit zu verdampfen. Durch die Verdampfung des Fluids wird den elektrischen Komponenten Wärme entzogen, wodurch diese gekühlt werden. Der durch die Verdampfung entstandene Dampf wird dann einem Wärmeübertrager zugeführt, der die Wärme durch eine Kondensation des Fluids an die Umgebung des Umrichters abgibt. Das kondensierte Fluid (Flüssigkeit) wird zu den zu kühlenden elektrischen Komponenten rückgeführt, sodass sich ein Kreislauf aus Verdampfung und Kondensation ausbildet. Zur Unterstützung des Kreislaufes, beispielsweise gegen die Erdbeschleunigung, kann dieser Kapillarstrukturen für das Fluid aufweisen.

Der vorliegenden Erfindung liegt die Aufgabe zugrunde eine Kühlvorrichtung zur Kühlung elektrischer Komponenten eines Umrichters bereitzustellen, die eine verbesserte Kühlung der genannten elektrischen Komponenten ermöglicht.

Die Aufgabe wird durch eine Kühlvorrichtung mit den Merkmalen des unabhängigen Patentanspruches 1, durch einen Umrichter mit den Merkmalen des unabhängigen Patentanspruches 10 sowie durch ein Verfahren mit den Merkmalen des unabhängigen Patenanspruches 12 gelöst. In den abhängigen Patentansprüchen sind vorteilhafte Ausgestaltungen und Weiterbildungen der Erfindung angegeben.

Die erfindungsgemäße Kühlvorrichtung zur Kühlung elektrischer Komponenten eines Umrichters umfasst wenigstens eine Kühlplatte mit einem ersten und einem zweiten Kühlbereich, wobei die Kühlbereiche mit einer Siedekühlvorrichtung thermisch gekoppelt sind. Erfindungsgemäß weist die Kühlvorrichtung wenigstens ein erstes Steuerelement auf, mittels welchem die Kühlleistung der Siedekühlvorrichtung wenigstens eines der Kühlbereiche steuerbar ist.

Als elektrische Komponenten werden insbesondere alle Komponenten oder Bauelemente oder Bauteile eines Umrichters angesehen, die während eines Betriebes des Umrichters eine thermische Verlustleistung aufweisen und somit Wärme oder Abwärme erzeugen. Insbesondere werden elektronische Komponenten als elektrische Komponenten angesehen.

Eine Siedekühlvorrichtung im Sinne der vorliegenden Erfindung ist jede Vorrichtung, welche mittels eines Phasenübergangs eines Kühlfluids, beispielsweise einer Verdampfung oder einem Sieden eines Kühlfluids, zur Kühlung beziehungsweise zur Bereitstellung einer Kühlleistung für die Kühlbereiche geeignet ist.

Die Kühlplatte beziehungsweise die zwei Kühlbereiche sind insbesondere zur Anordnung von zu kühlenden elektrischen Komponenten vorgesehen. Die elektrischen Komponenten können typischerweise in zwei Klassen eingeteilt werden, wobei die elektrischen Komponenten der erste Klasse eine vergleichsweise hohe Verlustleistung (verlustreiche Komponenten) und die elektrischen Komponenten der zweiten Klasse eine vergleichsweise geringe Verlustleitsung (verlustarme Komponenten) aufweist.

Vorteilhafterweise sind für eine Siedekühlvorrichtung keine bewegbaren Komponenten, beispielsweise Pumpen, erforderlich. Ein Vorteil der Siedekühlvorrichtung ist daher, dass diese sich typischerweise selbst steuert oder regelt. Beispielsweise wird mit steigender Verlustleistung mehr Dampf erzeugt. Dadurch erhöht sich der Druckverlust in den Leitungen der Siedekühlvorrichtung. Der erhöhte Druckverlust bedingt einen erhöhten Druck im Verdampfer der Siedekühlvorrichtung, so dass die Verdampfungstemperatur des Kühlfluids ansteigt. Die dadurch erhöhte Dampftemperatur erhöht gleichzeitig die Dichte des Dampfes, sodass sich der Druckverlust wieder reduziert. Weiterhin ist die Verdampfungstemperatur des Kühlfluids von der Kondensationstemperatur des Kühlfluids abhängig, die wiederum von der Temperatur des Kühlfluids an sich abhängt.

Erfindungsgemäß weist die Kühlvorrichtung die zwei Kühlbereiche auf. Hierbei kann erfindungsgemäß die Kühlleistung wenigstens eines der Kühlbereiche mittels des ersten Steuerelementes gesteuert werden. Dadurch ergeben sich zwei Kühlbereiche, die eine unterschiedliche Kühlleistung aufweisen können. Mit anderen Worten ist dadurch die Kühlleistung wenigstens eines der Kühlbereiche an die Verlustleistung der in diesem Kühlbereich angeordneten elektrischen Komponenten anpassbar.

Beispielsweise ist der erste Kühlbereich für elektrische Komponenten mit einer hohen Verlustleistung vorgesehen, wobei die Kühlleistung des ersten Kühlbereiches mittels des Steuerelementes steuerbar ist. Folglich kann die Kühlleistung für die verlustreichen elektrischen Komponenten mittels des Steuerelementes erhöht werden. Weiterhin kann die Kühlleistung der Siedekühlvorrichtung innerhalb des zweiten Kühlbereiches gegenüber dem ersten Kühlbereich geringer ausfallen. Insgesamt wird dadurch die Kühlung der elektrischen Komponenten des Umrichters mittels der erfindungsgemäßen Kühlvorrichtung effizienter. Mittels der erfindungsgemäßen Kühlvorrichtung wird es daher möglich die Kühlleistung der Siedekühlvorrichtung in wenigstens zwei Kühlbereichen der Kühlplatte zu steuern oder zu regeln. Dadurch kann die Temperatur in wenigstens einem der Kühlbereiche gesteuert und angepasst werden.

Gemäß einer vorteilhaften Ausgestaltung der Erfindung umfasst die Kühlvorrichtung ein zweites Steuerelement, mittels welchem die Kühlleistung der Siedekühlvorrichtung des weiteren Kühlbereiches steuerbar ist.

Vorteilhafterweise ist dadurch die Kühlleistung der Siedekühlvorrichtung in den zwei Kühlbereichen der Kühlvorrichtung steuerbar. Dadurch wird vorteilhafterweise die Effizienz der Kühlvorrichtung verbessert. Dass ist deshalb der Fall, da beispielsweise der erste Kühlbereich für verlustreiche elektrische Komponenten und der zweite Kühlbereich für verlustarme elektrische Komponenten vorgesehen ist und die jeweilige Kühlleistung auf die zu kühlenden Komponenten in den zwei Kühlbereichen getrennt voneinander anpassbar ist. Mit anderen Worten ist die Kühlleistung innerhalb der Kühlbereiche an die elektrische Verlustleistung der in den Kühlbereichen angeordneten elektrischen Komponenten anpassbar.

In einer vorteilhaften Weiterbildung der Erfindung ist die Siedekühlvorrichtung als ein Wärmerohr, insbesondere als eine Heat-Pipe oder ein Zweiphasen-Thermosiphon, ausgebildet.

Dadurch wird vorteilhafterweise die Effizienz der Kühlvorrichtung weiter verbessert. Typischerweise weist ein Wärmerohr einen Verdampfer, einen Kondensator und ein Leitungssystem für ein Kühlfluid, welches innerhalb des Verdampfers verdampft, innerhalb des Kondensators kondensiert und mittels des Leitungssystems geführt wird, auf.

Es ist daher besonders bevorzugt, wenn die Siedekühlvorrichtung zwei Verdampfer zum Verdampfen des Kühlfluids aufweist, wobei die zwei Verdampfer wenigstens teilweise mittels der zwei Kühlbereiche der Kühlplatte ausgebildet sind.

Mit anderen Worten wird das Kühlfluid durch die innerhalb der zwei Kühlbereiche angeordneten elektrischen Komponenten wenigstens teilweise zur Verdampfung gebracht. Der Dampf des Kühlfluids wird dann über das Leitungssystem zum Kondensator der Siedekühlvorrichtung geführt. Innerhalb des Kondensators der Siedekühlvorrichtung kondensiert das Kühlfluid wenigstens teilweise und gibt hierbei die durch seine Verdampfung aufgenommene Wärme, die der Verlustleistung der elektrischen Komponenten wenigstens teilweise entspricht, wenigstens teilweise an die Umgebung ab. Das kondensierte Kühlfluid wird dann wieder mittels des Leitungssystems zu den zwei Kühlbereichen der Kühlplatte rückgeführt. Hierbei weist die Siedekühlvorrichtung zwei Verdampfer und einen gemeinsamen Kondensator auf. Weiterhin sind die zwei Verdampfer und der gemeinsame Kondensator innerhalb eines gemeinsamen Leitungssystems angeordnet, wobei die zwei Verdampfer bezüglich des Massenstromes des Kühlfluids parallel verschaltet sind.

Hierbei kann die Siedetemperatur des Kühlfluids beispielsweise mittels einer Bimetall-Regelung innerhalb des Leitungsabschnittes des Dampfes gesteuert oder geregelt werden.

Gemäß einer vorteilhaften Ausgestaltung der Erfindung weist die Siedekühlvorrichtung ein Leitungssystem zur Führung des Kühlfluids auf, wobei das Leitungssystem einen für den ersten Kühlbereich ersten Leitungsabschnitt und einen für den zweiten Kühlbereich zweiten Leitungsabschnitt aufweist. Weiterhin ist hierbei die Kühlleistung des ersten Leitungsabschnittes mittels des ersten Steuerelementes und/oder die Kühlleistung des zweiten Leitungsabschnitts mittels des zweiten Steuerelementes steuerbar.

Mit anderen Worten sind den Kühlbereichen der Kühlvorrichtung verschiedene Leistungsabschnitte des Leitungssystems zugeordnet. Mittels des ersten und/oder zweiten Steuerelementes ist die Kühlleistung der Leitungsabschnitte beispielsweise durch eine Anpassung des Massenstromes des Kühlfluides und/oder des Druckes des Kühlfluides, steuerbar. Hierbei ist der erste Leitungsabschnitt zur Führung des Kühlfluids zum ersten Kühlbereich und der zweite Leitungsabschnitt zur Führung des Kühlfluids zum zweiten Kühlbereich der Kühlvorrichtung ausgebildet. Innerhalb der Kühlbereiche verdampft dann das Kühlfluid wenigstens teilweise innerhalb der Leitungsabschnitte durch die in den Kühlbereichen mittels der elektrischen Komponenten erzeugte Wärme. Hierbei sind die Leitungsabschnitte bezüglich des Massenstromes des Kühlfluids typischerweise parallel geschaltet.

In einer vorteilhaften Weiterbildung der Erfindung ist wenigstens eines der Steuerelemente als ein Steuerventil ausgebildet.

Bevorzugt sind beide Steuerelemente, das heißt das erste und das zweite Steuerelement jeweils als ein Steuerventil ausgebildet. Mit anderen Worten trennt sich das Leitungssystem in den ersten und zweiten Leitungsabschnitt auf, wobei für jeden Leitungsabschnitt ein Steuerventil vorgesehen ist. Dadurch wird es möglich die Temperatur beziehungsweise die Kühlleistung innerhalb der Kühlbereiche zu steuern. Beispielsweise wird der Druckverlust innerhalb des Leitungsabschnittes, der für verlustärmere Komponenten vorgesehen ist, erhöht, wodurch weniger Kühlfluid durch den genannten Leitungsabschnitt fließt und somit die Kühlleistung reduziert wird. Mit anderen Worten wird hierbei das Steuerventil gedrosselt. Dadurch wird die Temperatur innerhalb des dem Leitungsabschnitt zugeordneten Kühlbereiches tendenziell erhöht. Werden beide Steuerventile gedrosselt, so steigt die Temperatur innerhalb der Kühlbereiche, da der Gesamtdruckverlust der Siedekühlvorrichtung ansteigt. Wurde ein Arbeitspunkt der Siedekühlvorrichtung unter Berücksichtigung einer teilweisen Drosselung der Steuerventile ausgelegt, so sinkt die Verdampfungstemperatur des Kühlfluids beim Öffnen der Steuerventile.

Gemäß einer vorteilhaften Ausgestaltung der Erfindung umfasst die Kühlplatte die Leitungsabschnitte.

Dadurch wird vorteilhafterweise die thermische Kopplung zwischen der Kühlplatte und den Leitungsabschnitten und somit die thermischen Effizienz der Kühlvorrichtung verbessert.

Hierbei ist es besonders bevorzugt, wenn die Leitungsabschnitte mittels Bohrungen innerhalb der Kühlplatte ausgebildet sind.

Dadurch wird die thermische Kopplung zwischen der Kühlplatte und den Leitungsabschnitten beziehungsweise zwischen der Kühlplatte und dem Kühlfluid innerhalb der Leitungsabschnitte weiter verbessert.

In einer vorteilhaften Weiterbildung der Erfindung weist wenigstens einer der Leitungsabschnitte eine Mehrzahl von bezüglich des Kühlfluids fluidisch parallel gekoppelten Fluidkanälen auf, wobei sich die Fluidkanäle räumlich parallel zueinander erstrecken.

Hierbei können die Fluidkanäle bevorzugt mittels Bohrungen innerhalb der Kühlplatte ausgebildet sein. Vorteilhafterweise wird das Kühlfluid durch die Fluidkanäle innerhalb der Kühlbereiche großflächig verteilt. Dadurch kann besonders viel Wärme abgeführt werden.

Weiterhin werden elektrische Komponenten eines Umrichters typischerweise in verschiedenen geodätischen Höhen angeordnet. Da sich entlang der Kühlplatte der Druck des Kühlfluids ändert, ändert sich auch seine Verdampfungstemperatur entlang der Kühlplatte. Zusätzlich erhöht sich aufgrund der auf das Kühlfluid übertragenen thermischen Energie dessen Temperatur entlang der Kühlplatte. Zur Schaffung einer möglichst homogenen Temperatur- und Druckverteilung ist es daher von Vorteil die Mehrzahl von Fluidkanälen vorzusehen. Durch die Mehrzahl der Fluidkanäle, insbesondere der fluidisch parallel gekoppelten Fluidkanälen, kann der Massenstrom des Kühlfluids aktiv gesteuert werden und die Temperatur entlang der Kühlplatte annähernd konstant gehalten werden.

Erfindungsgemäß ist die Kühlplatte wenigstens zweiteilig ausgebildet, wobei ein erster Teil der Kühlplatte den ersten Kühlbereich und ein zweiter Teil der Kühlplatte den zweiten Kühlbereich umfasst.

Dadurch ergibt sich vorteilhafterweise ein modularer Aufbau. Weiterhin wird die thermische Isolierung zwischen dem ersten Kühlbereich und dem zweiten Kühlbereich verbessert.

Der erfindungsgemäße Umrichter umfasst eine Kühlvorrichtung gemäß der vorliegenden Erfindung oder einer ihrer Ausgestaltungen.

Es ergeben sich zur bereits genannten erfindungsgemäßen Kühlvorrichtung gleichartige und gleichwertige Vorteile des erfindungsgemäßen Umrichters.

Besonders bevorzugt weist der Umrichter eine erste und zweite Klasse von elektrische Komponenten auf, wobei die erste Klasse von elektrischen Komponenten eine höhere thermische Verlustleistung als die zweite Klasse von elektrischen Komponenten aufweist und die Komponenten der ersten Klasse im ersten Kühlbereich und die Komponenten der zweiten Klasse im zweiten Kühlbereich angeordnet sind, wobei mittels des ersten Steuerelementes die Kühlleistung der Siedekühlvorrichtung innerhalb des ersten Kühlbereiches gegenüber der Kühlleistung der Siedekühlvorrichtung innerhalb des zweiten Kühlbereiches erhöhbar ist.

Mit anderen Worten ist der erste Kühlbereich der Kühlvorrichtung für die verlustreichen elektrischen Komponenten, beispielsweise Bipolartransistoren mit isolierter Gate-Elektrode (englisch: Insulated-Gate Bipolar Transistor, kurz IGBT), vorgesehen. Der zweite Kühlbereich der Kühlvorrichtung ist für verlustärmere elektrische Komponenten, beispielsweise Kondensatoren, vorgesehen. Dadurch wird vorteilhafterweise die Kühlleistung möglichst an die Verlustleistung der elektrischen Komponenten des Umrichters angepasst und somit optimiert. Dadurch wird die energetische Effizienz des Umrichters verbessert.

Hierbei wird das Kühlfluid beziehungsweise dessen Kondensat typischerweise über das Leitungssystem auf beide Kühlbereiche verteilt. Im Stand der Technik wird über die parallel kommunizierenden Fluidkanäle, die den Kühlbereichen zugeordnet sind, die Siedetemperatur des Kühlfluids innerhalb des Kühlbereiches, der für die verlustarmen Komponenten vorgesehen ist, durch die verlustreichen Komponenten beeinflusst und bestimmt. Zur Verhinderung dieser Beeinflussung ist erfindungsgemäß wenigstens das erste Steuerelement vorgesehen, mittels welchem die Kühlleistung innerhalb der Kühlbereiche getrennt voneinander steuerbar ist.

Das erfindungsgemäße Verfahren zur Kühlung elektrischer Komponenten eines Umrichters gemäß der vorliegenden Erfindung ist dadurch gekennzeichnet, dass mittels des ersten Steuerelementes der Kühlvorrichtung die Kühlleistung der Siedekühlvorrichtung wenigstens einer der Kühlbereiche gesteuert wird. Es ergeben sich zur erfindungsgemäßen Kühlvorrichtung sowie zum erfindungsgemäßen Umrichter gleichartige und gleichwertige Vorteile des erfindungsgemäßen Verfahrens.

Hierbei ist es besonders bevorzugt, wenn als erstes und/oder zweites Steuerelement ein Steuerventil verwendet wird.

Weitere Vorteile, Merkmale und Einzelheiten der Erfindung ergeben sich aus dem im Folgenden beschriebenen Ausführungsbeispielen sowie anhand der Zeichnungen. Dabei zeigen schematisiert:
- Figur 1: einen Umrichter mit einer aus dem Stand der Technik bekannten Siedekühlvorrichtung;
- Figur 2: einen Umrichter mit einer Kühlvorrichtung gemäß einer ersten Ausgestaltung der vorliegenden Erfindung; und
- Figur 3: einen weiteren Umrichter mit einer Kühlvorrichtung gemäß einer zweiten Ausgestaltung der vorliegenden Erfindung.

Gleichartige, gleichwertige oder gleichwirkende Elemente können in den Figuren mit denselben Bezugszeichen versehen sein.

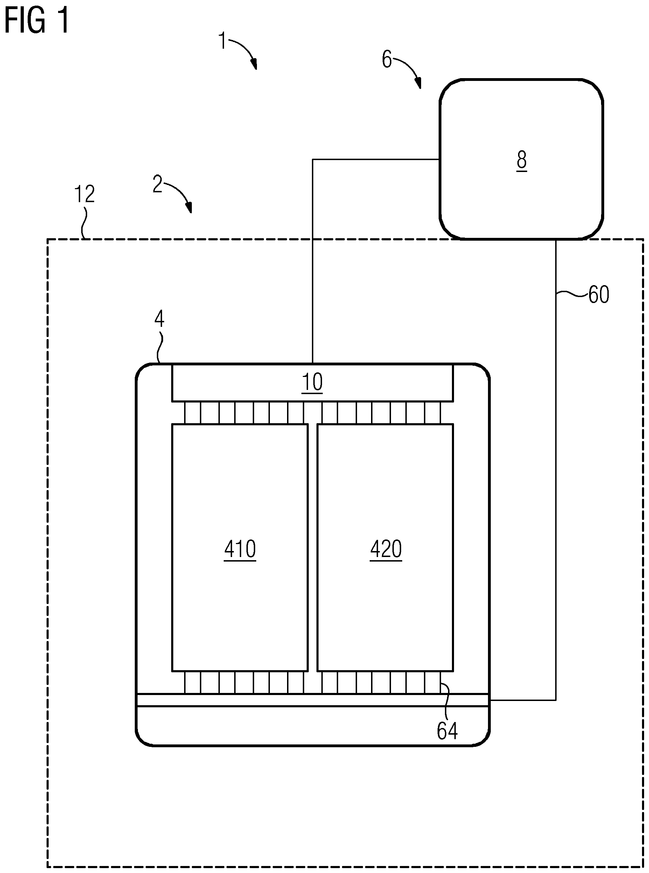

Figur 1 zeigt skizzenhaft den Umrichter 2, der eine nach dem Stand der Technik bekannte Kühlvorrichtung 1 aufweist. Hierbei ist die Kühlvorrichtung 1 als eine Siedekühlvorrichtung 6 ausgebildet. Die Siedekühlvorrichtung 6 umfasst ein Leitungssystem 60 und einen Kondensator 8.

Innerhalb eines Schrankes 12 des Umrichters 2 ist eine Kühlplatte 4 angeordnet. Die Kühlplatte 4 ist zur Anordnung elektrischer Komponenten vorgesehen sowie zu deren Kühlung. Hierzu ist die Kühlplatte 4 mit dem Leitungssystem 60 der Siedekühlvorrichtung 6 thermisch gekoppelt. Weiterhin weist die Kühlplatte 4 zur Kühlung der elektrischen Komponenten eine Mehrzahl von Fluidkanälen 64 auf, die bezüglich eines Kühlfluids innerhalb des Leitungssystems 60 fluidisch parallel verschaltet sind.

Die aus dem Stand der Technik bekannte Kühlvorrichtung 1 weist zwei Kühlbereiche 410, 420 auf, innerhalb welcher elektrische Komponenten unterschiedlicher Verlustleistung angeordnet sind oder werden. Innerhalb des ersten Kühlbereiches 410 sind beispielsweise verlustreiche elektrische Komponenten, insbesondere IGBTs angeordnet. Innerhalb des zweiten Kühlbereiches 420 sind dann vergleichsweise verlustarme elektrische Komponenten, beispielsweise Kondensatoren, angeordnet. Zur Kühlung der Kühlbereiche 410, 420 sind die Fluidkanäle 64 vorgesehen, die thermisch mit den Kühlbereichen 410, 420 gekoppelt sind und sich durch diese erstrecken.

Nachteilig am dargestellten Stand der Technik ist, dass es erforderlich ist die Kühlleistung innerhalb der Kühlbereiche 410, 420, die von der Siedekühlvorrichtung 6 bereitgestellt wird, an den verlustreichen Komponenten des ersten Kühlbereiches 410 auszulegen.

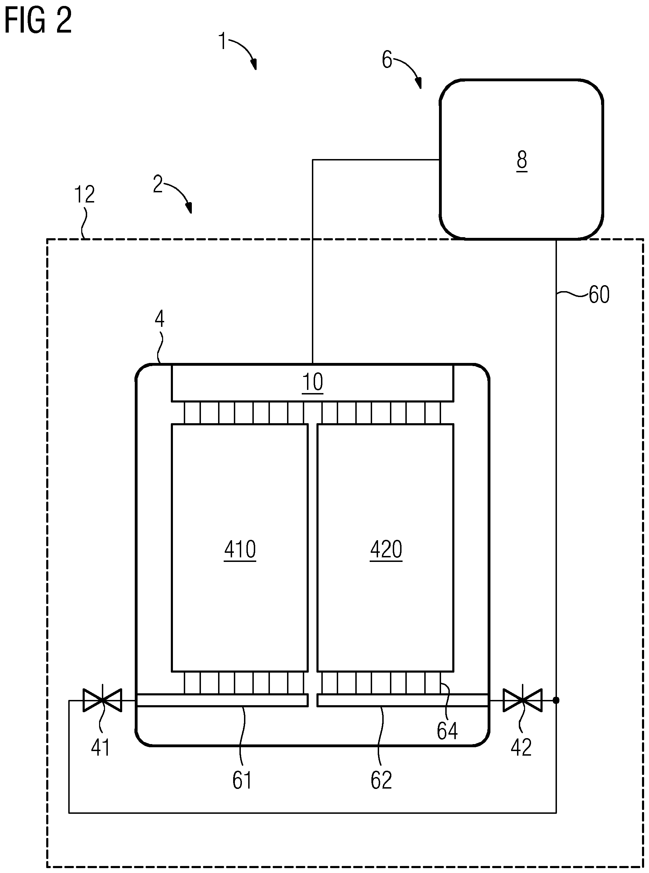

Zur Überwindung dieses Nachteils zeigt Figur 2 einen Umrichter mit einer Kühlvorrichtung 1 gemäß einer ersten Ausgestaltung der vorliegenden Erfindung.

Die Kühlvorrichtung 1 umfasst wiederum einen Kondensator 8, ein Leitungssystem 60, eine Kühlplatte 4 sowie zwei Kühlbereiche 410, 420. Weiterhin ist ein Dampfsammler 10 zum Sammeln des verdampften Kühlfluids und zur Rückführung des verdampften Kühlfluids zum Kondensator 8 vorgesehen.

Wie bereits in Figur 1 ist die Kühlvorrichtung 1 wenigstens teilweise innerhalb eines Schrankes 12 des Umrichters 2 angeordnet. Typischerweise wird der Kondensator 8 der Siedekühlvorrichtung 6 außerhalb des Schrankes 12 angeordnet. Dadurch wird die Wärme an die Umgebung des Umrichters 2 abgegeben. Die Kühlvorrichtung 1 weist ein erstes und zweites Steuerelement 41, 42 auf. Hierbei sind die Steuerelemente 41, 42 beispielhaft als Steuerventile ausgebildet.

Weiterhin weist das Leitungssystem 60 einen ersten Leitungsabschnitt 61 sowie einen zweiten Leitungsabschnitt 62 auf. Der Druck und/oder der Massenstrom des Kühlfluids innerhalb des ersten Leitungsabschnittes 61 kann mittels des ersten Steuerelementes 41 gesteuert oder geregelt werden. Analog kann der Druck und/oder der Massenstrom des Kühlfluids innerhalb des zweiten Leitungsabschnittes 62 mittels des zweiten Steuerelementes 42 gesteuert oder geregelt werden.

Dadurch wird es vorteilhafterweise möglich, die Kühlleistung der Siedekühlvorrichtung 6 innerhalb des ersten Kühlbereiches 410 und innerhalb des zweiten Kühlbereiches 420 zu steuern oder zu regeln. Beispielsweise wird die Kühlleistung des Siedekühlvorrichtung 6 innerhalb des ersten Kühlbereiches 410 gegenüber der Kühlleistung der Siedekühlvorrichtung innerhalb des zweiten Kühlbereiches 420 erhöht. Mit anderen Worten ist der erste Kühlbereich 410 für verlustreiche elektrische Komponenten und der zweite Kühlbereich 420 für verlustarme elektrische Komponenten des Umrichters 2 vorgesehen.

Zur Verteilung des flüssigen Kühlfluids innerhalb der Kühlbereiche 410, 420 ist eine Mehrzahl von Fluidkanälen 64 vorgesehen. Hierbei sind die Fluidkanäle 64 jeweils mit dem zugehörigen Leitungsabschnitt 61, 62 fluidisch gekoppelt. Zur Veranschaulichung ist nur einer der Fluidkanäle mit dem Bezugszeichen 64 gekennzeichnet. Die Fluidkanäle 64 erstrecken sich innerhalb ihres jeweiligen Kühlbereiches 410, 420 annähernd räumlich parallel zueinander. Eine räumlich mäanderförmige Erstreckung der Kühlkanäle 64 innerhalb der Kühlbereiche 410, 420 kann vorgesehen sein. Die Fluidkanäle 64 erstrecken sich in der dargestellten Figur 1 annähernd vertikal.

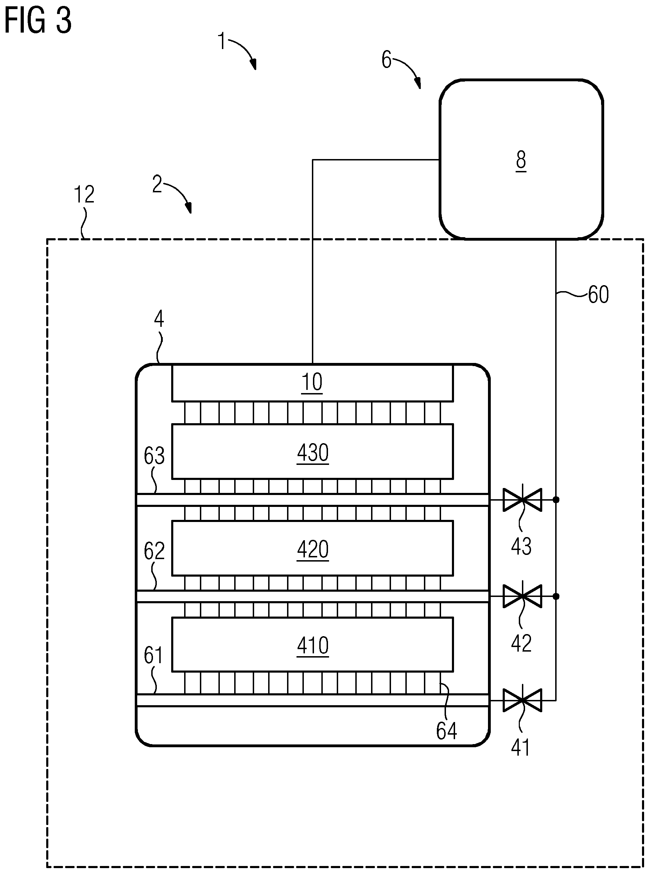

In Figur 3 ist ein weiterer Umrichter mit einer Kühlvorrichtung 1 gemäß einer zweiten Ausgestaltung der vorliegenden Erfindung dargestellt.

Die Kühlvorrichtung 1 in Figur 3 umfasst im Wesentlichen die Elemente der bereits in Figur 2 dargestellten Kühlvorrichtung.

Ergänzend zu Figur 2 weist die Kühlvorrichtung 1 in Figur 3 drei Kühlbereiche 410, 420, 430 auf. Jeder der Kühlbereiche 410, 420, 430 ist über einen zugehörigen Leitungsabschnitt 61, 62, 63 mit dem Leitungssystem 60 der Siedekühlvorrichtung 6 fluidisch gekoppelt. Zur Steuerung der Kühlleistung der Kühlbereiche 410, 420, 430 ist für jeden Leitungsabschnitt 61, 62, 63 wenigstens ein Steuerelement 41, 42, 43 vorgesehen. Hierbei sind die Steuerelemente 41, 42, 43 als Steuerventile ausgebildet und bezüglich des Kühlfluids der Siedekühlvorrichtung 6 parallel geschaltet.

Weiterhin weist die Kühlvorrichtung 1 ergänzend zur Kühlvorrichtung aus Figur 2 sich horizontal sowie sich vertikal erstreckende Fluidkanäle 64 auf. Hierbei erstrecken sich die horizontalen Fluidkanäle 64 wenigstens teilweise zwischen den Kühlbereichen 410, 420, 430.

Durch die vorliegende Erfindung wird eine selektive Steuerung oder Regelung der Kühlleistung innerhalb der Kühlbereiche ermöglicht. Hierbei sind die Kühlbereiche für verschieden verlustbehaftete elektrische Komponenten eines Umrichters vorgesehen. Dadurch wird die energetische Effizienz der Kühlung eines Umrichters verbessert.

Obwohl die Erfindung im Detail durch die bevorzugten Ausführungsbeispiele näher illustriert und beschrieben wurde, so ist die Erfindung nicht durch die offenbarten Beispiele eingeschränkt oder andere Variationen können vom Fachmann hieraus abgeleitet werden, ohne den Schutzumfang der Erfindung gemäß den Ansprüchen zu verlassen.

## Patentansprüche

1. Kühlvorrichtung (1) zur Kühlung elektrischer Komponenten eines Umrichters (2), umfassend wenigstens eine Kühlplatte (4) mit einem ersten und zweiten Kühlbereich (410, 420), wobei die Kühlplatte (4) wenigstens zweiteilig ausgebildet ist, und ein erster Teil der Kühlplatte den ersten Kühlbereich (410) und ein zweiter Teil der Kühlplatte (4) den zweiten Kühlbereich (420) umfasst, wobei die Kühlbereiche (410, 420) mit einer Siedekühlvorrichtung (6) umfassend ein Leitungssystem (60) und einen Kondensator (8) thermisch gekoppelt sind, und die Kühlvorrichtung (1) wenigstens ein erstes Steuerelement (41) aufweist, mittels welchem die Kühlleistung der Siedekühlvorrichtung(6) wenigstens eines der Kühlbereiche (410) steuerbar ist, wobei die Kühlplatte (2) einen Dampfsammler 10 zum Sammeln von verdampftem Kühlfluid und zu einer Rückführung des verdampften Kühlfluids zum Kondensator 8 umfasst.

2. Kühlvorrichtung (1) gemäß Anspruch 1, **dadurch gekennzeichnet, dass** diese ein zweites Steuerelement umfasst (42), mittels welchem die Kühlleistung der Siedekühlvorrichtung (6) des weiteren Kühlbereiches (420) steuerbar ist.

3. Kühlvorrichtung (1) gemäß Anspruch 1 oder 2, **dadurch gekennzeichnet, dass** die Siedekühlvorrichtung (6) als ein Wärmerohr, insbesondere als eine Heat-Pipe oder ein Zwei-Phasen-Thermosiphon, ausgebildet ist.

4. Kühlvorrichtung (1) gemäß Anspruch 3, **dadurch gekennzeichnet, dass** die Siedekühlvorrichtung (6) zwei Verdampfer zum Verdampfen eines Kühlfluids aufweist, wobei die zwei Verdampfer wenigstens teilweise mittels der zwei Kühlbereiche (410, 420) der Kühlplatte (4) ausgebildet sind.

5. Kühlvorrichtung (1) gemäß Anspruch 4, **dadurch gekennzeichnet, dass** die Siedekühlvorrichtung (6) ein Leitungssystem (60) zur Führung des Kühlfluids aufweist, wobei das Leitungssystem (60) einen für den ersten Kühlbereich (410) ersten Leitungsabschnitt (61) und einen für den zweiten Kühlbereich (420) zweiten Leitungsabschnitt (62) aufweist, wobei die Kühlleistung des ersten Leitungsabschnittes (61) mittels des ersten Steuerelementes (41) und/oder die Kühlleistung des zweiten Leitungsabschnittes (62) mittels des zweiten Steuerelementes (42) steuerbar ist.

6. Kühlvorrichtung (1) gemäß Anspruch 5, **dadurch gekennzeichnet, dass** wenigstens eines der Steuerelemente (41, 42) als ein Steuerventil ausgebildet ist.

7. Kühlvorrichtung (1) gemäß einem der Ansprüche 4 bis 6, **dadurch gekennzeichnet, dass** die Kühlplatte (4) die Leitungsabschnitte (61, 62) umfasst.

8. Kühlvorrichtung (1) gemäß Anspruch 7, **dadurch gekennzeichnet, dass** die Leitungsabschnitte (61, 62) mittels Bohrungen innerhalb der Kühlplatte (4) ausgebildet sind.

9. Kühlvorrichtung (1) gemäß einem der Ansprüche 5 bis 8, **dadurch gekennzeichnet, dass** wenigstens einer der Leitungsabschnitte (61, 62) eine Mehrzahl von bezüglich des Kühlfluids fluidisch parallel gekoppelten Fluidkanälen (63) aufweist, wobei sich die Fluidkanäle (63) räumlich parallel zueinander erstrecken.

10. Umrichter (2), **dadurch gekennzeichnet, dass** dieser wenigstens eine Kühlvorrichtung (1) gemäß einem der vorhergehenden Ansprüche umfasst.

11. Umrichter (2) gemäß Anspruch 10, **dadurch gekennzeichnet, dass** dieser eine erste und zweite Klasse von elektrischen Komponenten aufweist, wobei die erste Klasse von elektrischen Komponenten eine höhere thermische Verlustleitung als die zweite Klasse von elektrischen Komponenten aufweist, und die Komponenten der ersten Klasse im ersten Kühlbereich (410) und die Komponenten der zweiten Klasse im zweiten Kühlbereich (420) angeordnet sind, wobei mittels des ersten Steuerelementes (41) die Kühlleistung der Siedekühlvorrichtung (6) innerhalb des ersten Kühlbereiches (410) gegenüber der Kühlleistung der Siedekühlvorrichtung (6) innerhalb des zweiten Kühlbereiches (420) erhöhbar ist.

12. Verfahren zur Kühlung elektrischer Komponenten eines Umrichters (2), mit einem Umrichter gemäß Anspruch 10 oder 11, **dadurch gekennzeichnet, dass** mittels des ersten Steuerelements (41) der Kühlvorrichtung (1) die Kühlleistung der Siedekühlvorrichtung (6) wenigstens eines der Kühlbereiche (410) gesteuert wird.

13. Verfahren gemäß Anspruch 12, **dadurch gekennzeichnet, dass** mittels des zweiten Steuerelements (42) der Kühlvorrichtung (1) die Kühlleistung der Siedekühlvorrichtung (6) des weiteren Kühlbereiches (420) gesteuert wird.

14. Verfahren gemäß Anspruch 12 oder 13, **dadurch gekennzeichnet, dass** als erstes und/oder zweites Steuerelement (41, 42) ein Steuerventil verwendet wird.

## Claims

1. Cooling apparatus (1) for cooling electrical components of a converter (2), comprising at least one cooling plate (4) with a first and second cooling region (410, 420), wherein the cooling plate (4) is embodied in at least two parts, and a first part of the cooling plate comprises the first cooling region (410) and a second part of the cooling plate (4) the second cooling region (420), wherein the cooling regions (410, 420) are thermally coupled to an evaporative cooling apparatus (6) comprising a pipe system (60) and a condenser (8), and the cooling apparatus (1) has at least a first control element (41), by means of which the cooling capacity of the evaporative cooling apparatus (6) of at least one of the cooling regions (410) is able to be controlled, wherein the cooling plate (2) comprises a steam collector 10 for collecting evaporated cooling fluid and for guiding the evaporated cooling fluid back to the condenser 8.

2. Cooling apparatus (1) according to claim 1, **characterised in that** it comprises a second control element (42), by means of which the cooling capacity of the evaporative cooling apparatus (6) of the further cooling region (420) is able to be controlled.

3. Cooling apparatus (1) according to claim 1 or 2, **characterised in that** the evaporative cooling apparatus (6) is embodied as a thermal pipe, in particular as a heat pipe or a two-phase thermosiphon.

4. Cooling apparatus (1) according to claim 3, **characterised in that** the evaporative cooling apparatus (6) has two evaporators for evaporating a cooling fluid, wherein the two evaporators are at least partially embodied by means of the two cooling regions (410, 420) of the cooling plate (4).

5. Cooling apparatus (1) according to claim 4, **characterised in that** the evaporative cooling apparatus (6) has a pipe system (60) for guiding the cooling fluid, wherein the pipe system (60) has a first line section (61) for the first cooling region (410) and a second line section (62) for the second cooling region (420), wherein the cooling capacity of the first line section (61) is able to be controlled by means of the first control element (41) and/or the cooling capacity of the second line section (62) is able to be controlled by means of the second control element (42).

6. Cooling apparatus (1) according to claim 5, **characterised in that** at least one of the control elements (41, 42) is embodied as a control valve.

7. Cooling apparatus (1) according to one of claims 4 to 6, **characterised in that** the cooling plate (4) comprises the line sections (61, 62).

8. Cooling apparatus (1) according to claim 7, **characterised in that** the line sections (61, 62) are embodied by means of bore holes within the cooling plate (4).

9. Cooling apparatus (1) according to one of claims 5 to 8, **characterised in that** at least one of the line sections (61, 62) has a plurality of fluid ducts (63) which are fluidically coupled in parallel in relation to the cooling fluid, wherein the fluid ducts (63) extend in parallel with one another spatially.

10. Converter (2), **characterised in that** it comprises at least one cooling apparatus (1) according to one of the preceding claims.

11. Converter (2) according to claim 10, **characterised in that** it has a first and second class of electrical components, wherein the first class of electrical components has a higher thermal power loss than the second class of electrical components, and the components of the first class are arranged in the first cooling region (410) and the components of the second class in the second cooling region (420), wherein the first control element (41) can be used to increase the cooling capacity of the evaporative cooling apparatus (6) within the first cooling region (410) compared to the cooling capacity of the evaporative cooling apparatus (6) within the second cooling region (420).

12. Method for cooling electrical components of a converter (2), with a converter according to claim 10 or 11, **characterised in that** the cooling capacity of the evaporative cooling apparatus (6) of at least one of the cooling regions (410) is controlled by means of the first control element (41) of the cooling apparatus (1).

13. Method according to claim 12, **characterised in that** the cooling capacity of the evaporative cooling apparatus (6) of the further cooling region (420) is controlled by means of the second control element (42) of the cooling apparatus (1).

14. Method according to claim 12 or 13, **characterised in that** a control valve is used as the first and/or second control element (41, 42).

## Revendications

1. Installation (1) de refroidissement pour le refroidissement de composants électriques d'un convertisseur (2), comprenant au moins une plaque (4) de refroidissement, ayant une première et une deuxième régions (410, 420) de refroidissement, la plaque (4) de refroidissement étant constituée au moins en deux parties et une première partie de la plaque de refroidissement comprend la première région (410) de refroidissement et une deuxième partie de la plaque (4) de refroidissement comprend la deuxième région (420) de refroidissement, les régions (410, 420) de refroidissement étant couplées thermiquement à un système (6) de refroidissement par ébullition, comprenant un système (60) de conduit et un condenseur (8), et l'installation (1) de refroidissement a au moins un premier élément de commande, au moyen duquel la puissance de refroidissement de l'installation (6) de refroidissement par ébullition d'au moins l'une des régions (410) de refroidissement peut être réglée, la plaque (2) de refroidissement comprenant un collecteur 10 de vapeur pour collecter du fluide de refroidissement évaporé et pour un retour du fluide de refroidissement évaporé au condenseur (8).

2. Installation (1) de refroidissement suivant la revendication 1, **caractérisée en ce qu'**elle comprend (42) un deuxième élément de commande, au moyen duquel la puissance de refroidissement de l'installation (6) de refroidissement par ébullition de l'autre région (420) de refroidissement peut être réglée.

3. Installation (1) de refroidissement suivant la revendication 1 ou 2, **caractérisée en ce que** l'installation (6) de refroidissement par ébullition est constituée sous la forme d'un caloduc, notamment d'un heat-pipe ou d'un thermosiphon à deux phases.

4. Installation (1) de refroidissement suivant la revendication 3, **caractérisée en ce que** l'installation (6) de refroidissement par ébullition a deux évaporateurs pour l'évaporation d'un fluide de refroidissement, les deux évaporateurs étant constitués, au moins en partie, au moyen des deux régions (410, 420) de refroidissement de la plaque (4) de refroidissement.

5. Installation (1) de refroidissement suivant la revendication 4, **caractérisée en ce que** l'installation (6) de refroidissement par ébullition a un système (60) de conduit pour conduire le fluide de refroidissement, le système (60) de conduit ayant un premier tronçon (61) de conduit pour la première région (410) de refroidissement et un deuxième tronçon (62) de conduit pour la deuxième région (420) de refroidissement, la puissance de refroidissement du premier tronçon (61) de conduit pouvant être réglée au moyen du premier élément (41) de commande et/ou la puissance de refroidissement du deuxième tronçon (62) de conduit pouvant être réglée au moyen du deuxième élément (42) de commande.

6. Installation (1) de refroidissement suivant la revendication 5, **caractérisée en ce qu'**au moins l'un des éléments (41, 42) de commande est constitué sous la forme d'une vanne pilote.

7. Installation (1) de refroidissement suivant l'une des revendications 4 à 6, **caractérisée en ce que** la plaque (4) de refroidissement comprend les tronçons (61, 62) de conduit.

8. Installation (1) de refroidissement suivant la revendication (7) **caractérisée en ce que** les tronçons (61, 62) de conduit sont constitués au moyen de trous dans la plaque (4) de refroidissement.

9. Installation (1) de refroidissement suivant l'une des revendications 5 à 8, **caractérisée en ce qu'**au moins l'un des tronçons (61, 62) de conduit a une pluralité de canaux (63) pour du fluide, couplés en parallèle fluidiquement en ce qui concerne le fluide de refroidissement, les canaux (63) pour du fluide s'étendant parallèlement entre eux dans l'espace.

10. Convertisseur (2), **caractérisé en ce qu'**il comprend au moins une installation (1) de refroidissement suivant l'une des revendications précédentes.

11. Convertisseur (2) suivant la revendication 10, **caractérisé en ce qu'**il a une première et une deuxième classes de composants électriques, la première classe de composants électriques ayant une conduction thermique de perte plus grande que la deuxième classe de composants électriques et les composants de la première classe sont disposés dans la première région (410) de refroidissement et les composants de la deuxième classe sont disposés dans la deuxième région (420) de refroidissement, dans lequel, au moyen du premier élément (41) de commande, la puissance de refroidissement de l'installation (6) de refroidissement par ébullition peut être plus grande dans la première région (410) de refroidissement, que la puissance de refroidissement de l'installation (6) de refroidissement par ébullition dans la deuxième région (420) de refroidissement.

12. Procédé de refroidissement de composants électriques d'un convertisseur (2), comprenant un convertisseur suivant la revendication 10 ou 11, **caractérisé en ce que**, au moyen du premier élément (41) de commande de l'installation (1) de refroidissement, on règle la puissance de refroidissement de l'installation (6) de refroidissement par ébullition d'au moins l'une des régions (410) de refroidissement.

13. Procédé suivant la revendication (12), **caractérisé en ce que** l'on règle, au moyen du deuxième élément (42) de commande de l'installation (1) de refroidissement, la puissance de refroidissement de l'installation (6) de refroidissement par ébullition de l'autre région (420) de refroidissement.

14. Procédé suivant la revendication 12 ou 13, **caractérisé en ce que** l'on utilise, comme premier et/ou deuxième éléments (41, 42) de commande, une vanne pilote.
